# EUROPEAN PATENT APPLICATION

(11) **EP 2 071 912 A2**
(43) Date of publication of application: **17.06.2009**
(21) Application number: 08170381.1
(22) Date of filing: 01.12.2008
(51) Int. Cl.: H05K 7/20

(54) **Means to utilize conduction-cooled electronics modules in an air cooled system**

(30) Priority: 11.12.2007 US 8191 P; 29.10.2008 US 260315
(71) Applicant: Honeywell International Inc., Morristown, NJ 07962 (US)
(72) Inventor: Mantych, Glen, P.O Box 2245 Morristown, NJ 07962-2245 (US); Stanke, Jay, P.O. Box 2245 Morristown, NJ 07962-2245 (US); Hensley, Tom, P.O. Box 2245 Morristown, NJ 07962-2245 (US)
(74) Representative: Buckley, Guy Julian

(57) **Abstract**

A means to utilize conduction-cooled VME electronics modules in an air cooled system is provided. Such means comprises a modified convection-cooled VME compatible chassis that includes a convection bridge thermally interfaced with a VME electronics module just as a conduction chassis would. The convection bridge is clamped between the VME electronics module and the modified chassis, requiring no modifications to the VME electronics module. For enhanced performance, additional features may include having any individual or combination of fin orientation on the convection bridge, interstitial material such as grease or indium foil can be inserted between the convection bridge and the VME electronics module, and compatible air-moving appliances such as a fan as part of the modified VME chassis.

## Description

### CROSS-REFERENCE TO RELATED APPLICATIONS

The present application claims priority to U.S. Provisional Patent Application No. 61/008,191 filed on December 11, 2007 entitled "Means to Utilize Conduction Cooled 6U VME Electronics Modules in an Air Cooled Avionics System", the entire contents of which are incorporated herein for all purposes.

### FIELD OF THE INVENTION

The present invention relates to conduction-cooled electronics modules, and more particularly a means to adapt existing conduction-cooled electronics modules into a convection-cooled chassis.

### BACKGROUND OF THE INVENTION

Electronics modules are incorporated into modern systems for a variety of functions, ranging from basic communications and navigation in commercial aircraft to complex Airborne Early Warning (AEW) systems in military aircraft or battlefield management systems in ground vehicles. A primary high end electronics module standard used in the industry is the 6U Versa Module Eurocard (VME).

Existing high reliability, conduction cooled, 6U VME electronics modules for use in high performance avionics systems such as those in the F-18 or F-15 aircraft are maintained at operational temperatures by thermal conduction to cold walls. However, many ground vehicles and aircraft platforms, such as helicopters, do not have refrigerated cooling systems and rely on low pressure ambient air for temperature moderation.

As a result, a means to utilize conduction-cooled electronics modules in an air cooled system is desired.

### SUMMARY

According to one embodiment of the present invention, there is provided a modified convection-cooled VME compatible chassis that includes a convection bridge thermally interfaced with a VME electronics module just as a conduction chassis would. No modification to the VME electronics module is required, since the convection bridge is clamped or otherwise placed between the VME electronics module and the modified chassis. To enhance heat dissipation, an alternative embodiment of the present invention comprises fins (oriented in a direction other than horizontally) on the convection bridge. For better heat transfer, another alternative embodiment of the present invention comprises interstitial material such as grease or indium foil between the convection bridge and the VME electronics module. To improve convection properties, another alternative embodiment of the present invention comprises compatible air-moving appliances, such as a fan, as part of the modified VME chassis.

### BRIEF DESCRIPTION OF THE DRAWINGS

Fig. 1 is a pictorial diagram showing an exploded view of an enhanced 6U VME module, according to embodiments of the invention.
Fig. 1A shows a front view of the finned-convection-bridge heat exchanger 104, according to embodiments of the invention.
Fig. 2 is a pictorial diagram showing the assembled view of an enhanced 6U VME module, according to embodiments of the invention.
Fig. 3 is a pictorial diagram showing an enhanced 6U VME module installed in a convection-cooled chassis, according to embodiments of the invention.
Fig. 4 is a cross-sectional diagram showing the interface of an enhanced 6U VME module, according to embodiments of the invention.
Fig. 5 is a cross-sectional diagram showing the function of multiple enhanced 6U VME modules, according to embodiments of the invention.

### DETAILED DESCRIPTION

The present invention provides a means for adapting conduction-cooled electronics modules into a convection-cooled chassis, wherein a conduction-cooled module is modified by mounting a finned cooling plate or "convection bridge" to the heat dissipative surfaces of the module. The fins of the convection bridge create a large surface area and a low resistance air path through the avionics chassis. Thus, the finned convection bridge permits increased air flow through the avionics chassis, cooling the conduction-cooled electronics module by convection cooling. The concept utilizes additional card slots in the chassis to achieve the surface area necessary to provide adequate cooling with low pressure ambient air.

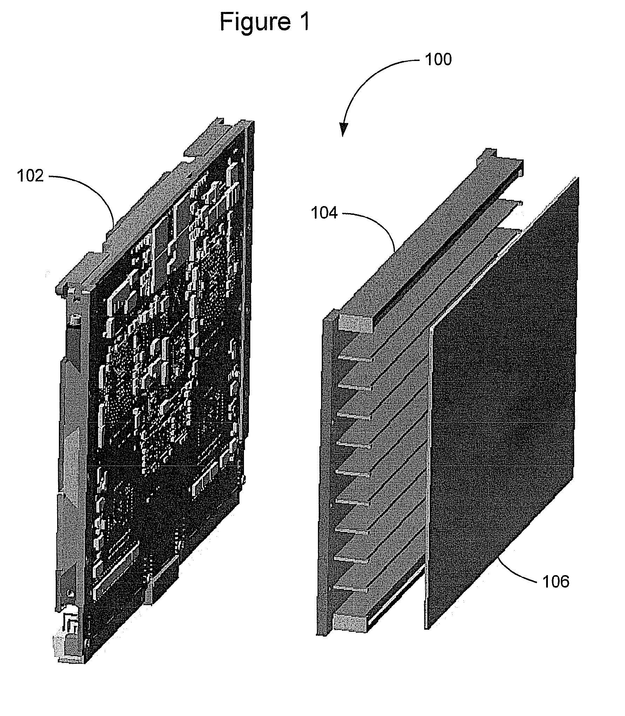

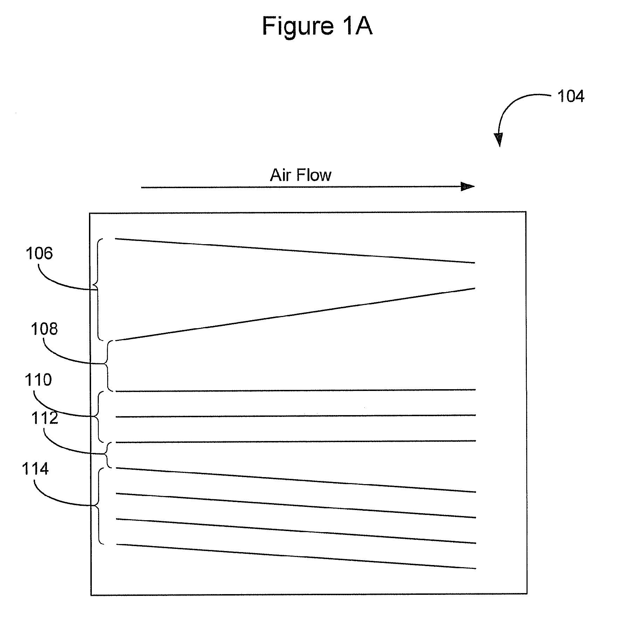

Fig. 1 is a pictorial diagram showing an exploded view of an enhanced 6U VME electronics module 100, according to one embodiment of the invention. The enhanced 6U VME electronics module 100 comprises a standard 6U VME electronics module 102 (that would normally be conduction cooled), a finned-convection-bridge heat exchanger 104, and a cover plate 106. The finned-convection-bridge heat exchanger 104 can be fabricated from a thermally conductive material such as aluminum and mounts adjacent to the existing standard 6U VME electronics module 102, occupying the space that would normally contain an adjacent module. The fins on the finned-convection-bridge heat exchanger 104 create a larger surface area with low resistance to convection air flow.

The fins on the finned-convection-bridge heat exchanger 104 are stationary fins; that is, they are not designed to move once the finned-convection-bridge heat exchanger 104 is manufactured. However, the fins on the finned-convection-bridge heat exchanger 104 may be mounted in the same orientation or in different orientations. For example, the fins on the finned-convection-bridge heat exchanger 104 may be mounted such that they are in the same direction, such as shown in the finned-convection-bridge heat exchanger 104.

Figure 1A shows a front view of the finned-convection-bridge heat exchanger 104, in accordance with embodiments of the invention. The fins on the finned-convection-bridge heat exchanger 104 may be mounted along different orientations, such as converging toward a point, diverging from a point, or parallel lines.

The finned-convection-bridge heat exchanger 104 depicted in Figure 1A has a pair of converging fins 106 that are converging toward a point (when traversed in the direction of air flow shown in Figure 1A), two pairs of diverging fins 108 and 112 that are diverging from a point, and two sets of parallel fins 110 and 114. Note that if the direction of air flow is changed (e.g., reversed) a pair of diverging fins may be considered converging fins and vice versa.

As such, adaptation of the standard 6U VME electronics module 102 using a finned-convection-bridge heat exchanger 104 allows the use of the standard 6U VME electronics module 102 in a convection-cooled chassis by having the convection finned-convection-bridge heat exchanger 104 act as the thermal conducting interface just as a conduction chassis would otherwise interface with the standard conduction-cooled 6U VME electronics module 102. Further, the enhanced 6U VME electronics module 100 as described may mechanically secured in a convection-cooled chassis by wedgelocks in the same manner that a standard 6U VME conduction-cooled electronics module 102 is mechanically secured in a conduction-cooled chassis.

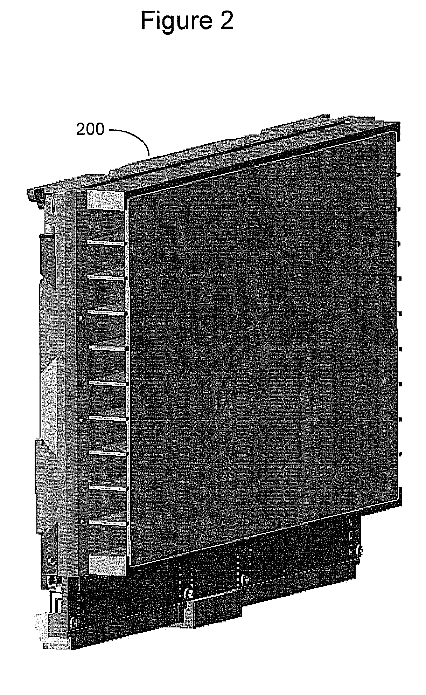

The cooling performance of this adaptation can be further enhanced by use of an interstitial material such as grease or indium foil between the standard 6U VME conduction-cooled electronics module 102 and the finned-convection-bridge heat exchanger 104. Fig. 2 is a pictorial diagram showing an enhanced 6U VME electronics module 200, according to one embodiment of the invention. This is the form in which the electronics module is installed into a wider slot in a conduction-cooled chassis, according to one embodiment of the present invention.

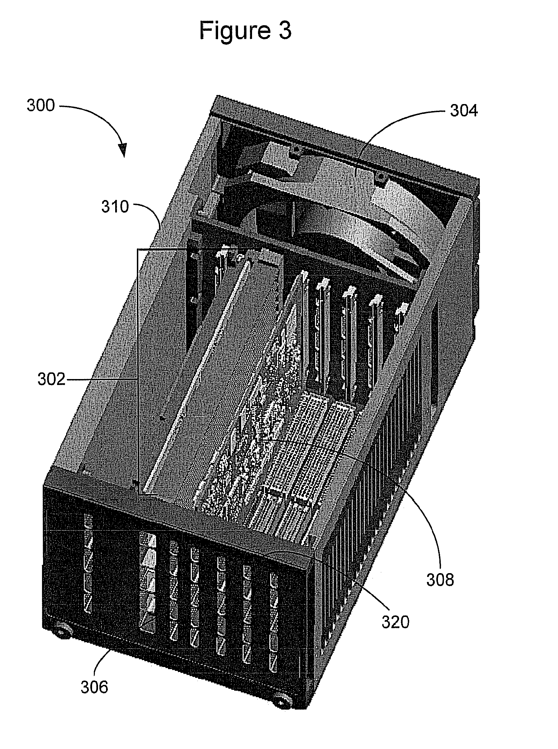

Fig. 3 is a pictorial diagram showing a configuration 300 with an enhanced 6U VME module 302 installed in a chassis 310, according to one embodiment of the invention. The configuration 300 comprises an enhanced 6U VME electronics module 302, a fan 304, air inlets 306, a standard conduction-cooled 6U VME electronics module 308, and a chassis 310. The chassis 310 also may comprise external air flow openings 320. The chassis 310 is an example of a chassis that uses an air-moving appliance, such as the fan 304, to help cool the electronics modules. The fan 304 may or may not be integral to the chassis.

As shown, the enhanced 6U VME module 302 uses a wider chassis slot interface and takes up the space of two modules when compared to the standard 6U VME conduction-cooled electronics module 308. As discussed before, the enhanced 6U VME electronics module 302 comprises a standard 6U VME conduction cooled electronics module coupled with a convection bridge heat exchanger, such as finned-convection-bridge heat exchanger 104 described with respect to Figure 1 above. In this embodiment, the orientations of the fins on the convection bridge heat exchanger may be optimally placed when the fins permit air flows in directions other than horizontal with respect to the external air flow openings 320. For example, if air flow from the fan 304 is in a direction other than horizontal with respect to the external air flow openings 320, the optimal orientation of the fins may be in or near the direction of air flow from the fan 304.

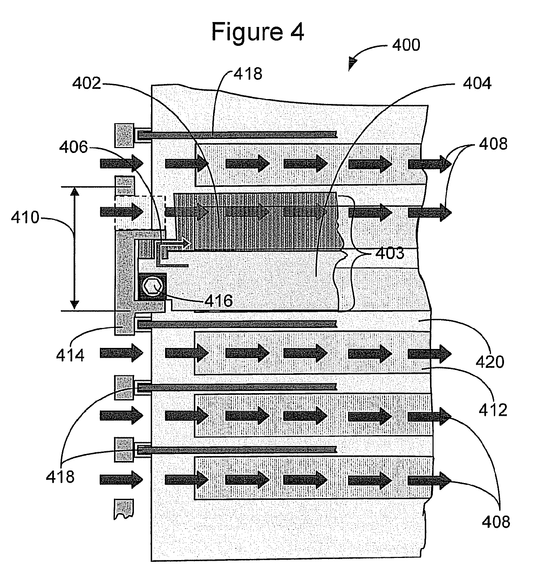

Fig. 4 is a cross-sectional diagram showing the chassis interface 400 of an enhanced 6U VME module, according to one embodiment of the invention. The cross-sectional diagram shows the enhanced 6U VME module 403 combined in a chassis with non-conduction-cooled standard 6U VME modules 418. The chassis interface 400 comprises convection bridge heat exchanger 402, standard 6U VME electronics module 404, a heat flow 406, an air flow 408, a card slot pitch height 410, generic 6U VME backplane 420, generic 6U VME connectors 412, a modified chassis side panel 414, a wedgelock clamp 416, and non-conduction-cooled standard 6U VME modules 418. As discussed above the pairing of a convection bridge heat exchanger 402 and standard 6U VME electronics module 404 forms the enhanced 6U VME electronics module 403 according to an embodiment of the present invention.

The purpose of the modified chassis side panel 414 is to provide air inlets so that air can be drawn through in the case of the chassis comprising a fan or any air-moving appliance. The air inlets can take different forms, from large air vents to small air holes. The chassis may need an increased slot width for this configuration, but as long as the card slot pitch height 410 is a multiple of 0.8 inches, compatibility with generic VME backplanes is maintained. Adaptations of electronics modules into convection-cooled chassis will typically entail pairing of the finned-convection-bridge heat exchanger with the existing product and replacement of the existing chassis side panels with modified chassis panels 414.

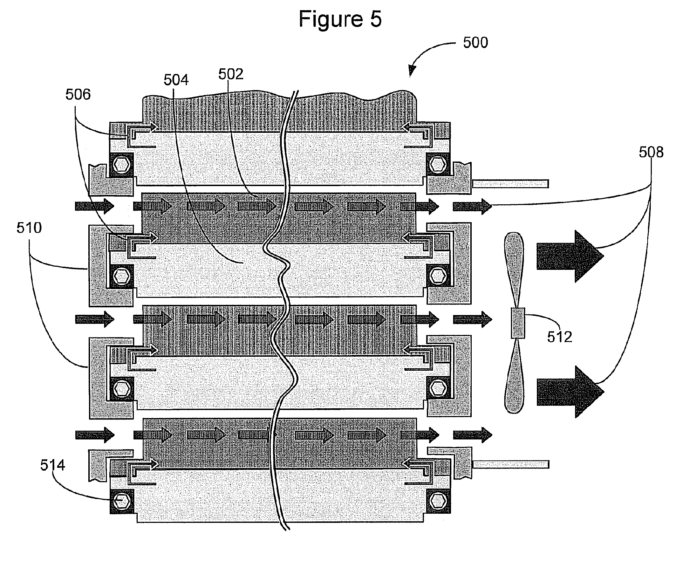

Fig. 5 is a cross-sectional diagram showing the function of an enhanced 6U VME module, according to one embodiment of the invention. The enhanced 6U VME module function 500 comprises a 6U VME convection bridge 502, standard 6U VME electronics module 504, heat flows 506, air flows 508, a modified chassis side panel 510, a fan 512, and a wedgelock clamp 514. Heat flows 506 allow heat to be dissipated from the standard 6U VME electronics module 504 to the convection bridge 502. The air flows 508 created by the fan 512 then carry the heat out from the convection bridge 502, resulting in a cooling effect.

One embodiment of the present invention provides a means to utilize standard 6U VME conduction-cooled electronics modules designed for high end aircraft in other system applications without refrigerated cooling systems, saving money and time by eliminating the need to redesign modules for ambient air cooled applications. Alternate embodiments of the present invention may include the convection bridge heat exchanger being permanently mounted to the chassis, allowing direct insertion of standard 6U VME conduction-cooled electronics modules into the chassis. One of ordinary art in the skill should find that similar adaptations of the present invention can be implemented for other standard VME dimensions such as 3U or 9U modules.

## Claims

1. An apparatus, comprising:
a chassis, comprising slots for electronics modules;
a convection bridge, inserted into a slot of the chassis, comprising a fin; and
an electronics module, inserted in a slot of the chassis adjacent to the convection bridge such that the convention bridge permits increased air flow through the chassis to cool the electronics module.

2. The apparatus of claim 1, wherein the convection bridge comprises at least one set of parallel fins.

3. The apparatus of claim 1, wherein the convection bridge comprises at least one set of converging fins.

4. The apparatus of claim 1, wherein at least one side panel of the chassis is configured to mount the convection bridge and the electronics module.

5. The apparatus of claim 1, wherein the chassis comprises a wedgelock clamp configured to clamp the convection bridge to the convection module.

6. The apparatus of claim 1, wherein the electronics module comprises one or more external-connector openings.

7. The apparatus of claim 6, wherein the fin is configured to cause airflow in a horizontal direction with respect to the external-connector openings.

8. The apparatus of claim 1, further comprising inserting interstitial material between the electronics module and convection bridge, wherein the interstitial material enhances conduction cooling.

9. The apparatus of claim 1, wherein the chassis further comprises an air-moving appliance configured to move warm air adjacent to the convection bridge out of the chassis.

10. The apparatus of claim 9, wherein the air-moving appliance is configured to be integral to the chassis.
